Europäisches Patentamt

European Patent Office

Office européen des brevets

(11) Publication number : **0 506 602 A2**

# (12) EUROPEAN PATENT APPLICATION

(21) Application number : **92630036.9**

(22) Date of filing : **26.03.92**

(51) Int. Cl.⁵ : **G01R 31/00**

(30) Priority : **27.03.91 IL 97694**

(43) Date of publication of application :
**30.09.92 Bulletin 92/40**

(84) Designated Contracting States :
**AT BE CH DE ES FR GB IT LI NL SE**

(71) Applicant : **AMIT ELECTRONICS AND ENGINEERING LTD.**
**15 Rehov Hashuk**
**Tel Aviv (IL)**

(72) Inventor : **Hendel, Mordechai**
**Kibbutz Mishmar Hasharon 69082**
**Tel Aviv (IL)**

(74) Representative : **Waxweiler, Jean**
**OFFICE DENNEMEYER & ASSOCIATES Sàrl,**
**P.O. Box 1502**
**L-1015 Luxembourg (LU)**

(54) **Device and method for GFCI time response and ground test.**

(57)    In an electrical system having line, neutral and ground connections and being protected by a ground fault circuit interrupter (GFCI) device, a test device (10) and method for measuring the operational response time of the GFCI device in a test procedure. The test device comprises a test button (16a-b) for applying a ground fault current to initiate the test procedure, a test stage (12) for detecting the applied ground fault current and measuring a time period elapsed between the detection and an occurrence of the GFCI device operation, a logic stage (14) for comparing the elapsed time period with a predetermined response time period and for indicating a performance result of the GFCI device determined by the greater of the elapsed time period and the predetermined response time period.

FIG-1

EP 0 506 602 A2

FIELD OF THE INVENTION

The present invention relates to a electrical testing devices associated with electrical power distribution networks, and more particularly, to a device and method for testing the response time of a ground fault circuit interrupter (GFCI), and determining as part of the test, whether a proper ground connection exists at an electrical socket.

BACKGROUND OF THE INVENTION

It is known to use electrical safety devices in residential electrical power systems, such as a ground fault circuit interrupter (GFCI), which is designed to reduce the risk of electrocution. This unit is also known as an earth leakage circuit breaker (ELCB).

A test procedure for the GFCI device is performed by manually depressing a button provided to actuate a contact and insert a test resistor in the circuit, causing fault current which leads to tripping of the breaker. The parameter of response time is not a factor in this test when performed at a user location. The GFCI response time is initially tested in the production stage, and a unit which does not comply with the standard is rejected. However, as an installed GFCI ages with time, the friction in its internal mechanism becomes higher, and the internal balance of its springs may change to such a degree that the unit no longer operates.

A properly functioning GFCI has to respond within a specified time when exposed to a full sine wave fault current of a specified amplitude. Ralsing the limit of the response time to as much as twice this value results in a response time threshold beyond which the GFCI does not fulfill its protective function.

Thus, in the prior art, testing a GFCI with its built-in test button is not sufficient, since the user is not provided with any response time information. A human eye cannot measure the difference between 40 and 90 milliseconds which is required to detect a faulty GFCI device.

Therefore, it would be desirable to provide a testing device which can determine the response time of the GFCI, and provide the user with useful information about its performance, enabling the user to decide whether or not to replace it.

Another test procedure for determining the safety aspects of residential electrical power distribution systems is performed by an instrument for testing whether a ground conductor exists at the socket, and if so, whether it is properly wired to the ground potential. The test procedure is based on connecting a high resistance (test resistor) between the hot point (line) to ground in series with a small neon bulb. If the socket ground terminal is indeed grounded somewhere, current will flow, energizing the bulb and indicating that the socket is properly grounded.

Performance of this test exposes the user to an electrical hazard which may be fatal, because, in the normal case, more than one electrical socket is connected in parallel. Thus, if the grounding wire which runs between sockets is not connected to true ground, when the test is carried out at one socket, a high potential is applied to the grounding wire of each socket. If a given socket feeds an appliance having a substantial metal body surface, at the moment the test is performed, the appliance body becomes "hot" and a person touching this body will get a possibly fatal electrical shock, since he is connected to the line voltage, via the test resistor.

Therefore, it would be desirable to provide a testing device which performs the grounding test at a safe voltage level.

SUMMARY OF THE INVENTION

Accordingly, it is a principal object of the present invention to provide a device and method for testing the response time of a GFCI by monitoring the elapsed time between the initiation of the test and the moment when the GFCI responds and power is cut off.

Another object of the invention is to provide a device and method for testing, at a safe voltage level, whether a ground conductor at an electrical socket is properly grounded.

In accordance with a preferred embodiment of the present invention, there is provided in an electrical system having line, neutral and ground connections and being protected by a ground fault circuit interrupter (GFCI) device, a test device for measuring an operational response time of the GFCI device in a test procedure, said test device comprising:

means for applying a ground fault current to initiate the test procedure, said ground fault current developing a voltage at said ground connection with respect to neutral if the ground connection has non-zero impedance;

means for limiting said voltage to a low value, if said voltage is developed at the ground connection;

means for detecting said applied ground fault current and measuring a time period elapsed between said detection and an occurrence of the GFCI device operation;

means for comparing said elapsed time period with a predetermined response time period; and

means responsive to said comparing means for indicating a performance result of the GFCI device determined by the greater of said elapsed time period and said predetermined response time period.

In the preferred embodiment, the test device is designed for testing a GFCI device which is installed to protect against ground fault currents in an electrical system. The test device is provided as a portable plug-in unit which can be plugged into a household electrical socket for testing purposes. A test button on the device creates a ground fault current between the line and ground terminals of the socket. A feature of the inventive test device is the provision of a test button cover to prevent inadvertent pressing of the test button.

If the socket is properly grounded, and the GFCI is functioning, the ground fault current operates the GFCI device protecting the system, cutting off electrical power.

In this case, a charging voltage is provided by the test device for the duration of the time period between the initiation of the test procedure and the GFCI device operation. The charging voltage is fed to a capacitor where it develops a voltage level which is compared with a predetermined voltage level representing the time period associated with a proper response time of the GFCI device.

If the voltage level representing the elapsed time period for GFCI device operation exceeds the predetermined voltage level representing the proper response time, a logic state is stored in a capacitor. After resetting the GFCI device and restoring power to the system after the test, this stored logic state is used to provide an indication that the GFCI device is not in proper operational condition.

If however, the charging voltage develops a voltage level on the capacitor which does not exceed the predetermined voltage level representing a proper GFCI device response time period, an indication is provided that its operation is in order. provided that a proper ground connection exists.

When the test button is first pressed to initiate the test procedure, the possibility exists that the socket is not properly grounded. In this case, instead of applying the full line voltage to the ground terminal, the test device automatically limits the rise in ground wire potential to a maximum of 30 volts. An indication of a "bad" ground connection is also provided.

A reset button is also provided with the test device to erase the results stored as a logic state on the capacitor, enabling performance of the test at another electrical socket. The storage time for the test results is approximately 5 minutes. A selector is also provided to select the sensitivity of the test.

Due to its innovative design, the inventive test device and method provides an additional level of information in verifying the proper operation of the GFCI and the grounding connection of the electrical socket, assuring additional safety.

Other features and advantages of the invention will become apparent from the drawings and the description contained hereinbelow.

BRIEF DESCRIPTION OF THE DRAWINGS

For a better understanding of the invention with regard to the embodiments thereof, reference is made to the accompanying drawings, in which like numerals designate corresponding elements or sections throughout, and in which:

Fig. 1 is an electronic schematic diagram of a test device constructed and operated in accordance with the principles of the present invention, for testing a GFCI response time; and

Fig. 2 is an electronic schematic diagram of a portion of the test device of Fig. 1, showing a modified arrangement for testing the ground impedance connection at an electrical socket.

DETAILED DESCRIPTION OF THE PREFERRED EMBODIMENTS

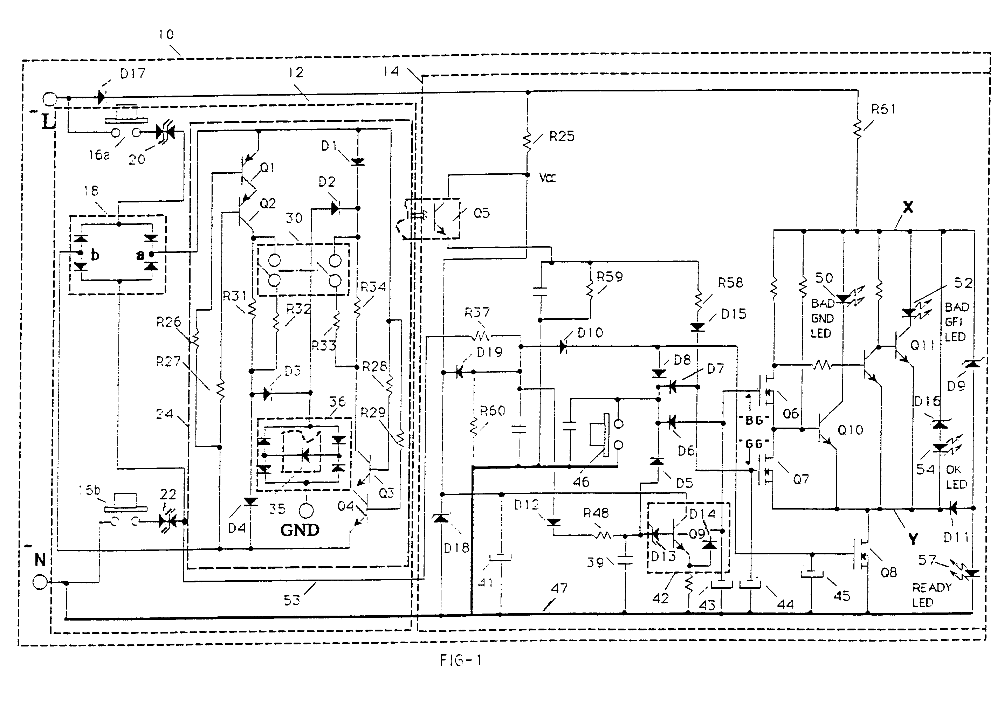

Referring now to Fig. 1, there is shown an electronic schematic diagram of a preferred embodiment of a test device 10 constructed and operated in accordance with the principles of the present invention, for testing the response time of a ground fault circuit interrupter (GFCI) device. Test device 10 is typically designed as a small, portable plug-in unit for use in a regular household socket. It is also designed to test the quality of the ground connection at the socket.

Where a proper ground connection exists, when a ground fault current test is initiated by test device 10, the GFCI device associated with the household electrical wiring will respond, cutting off electrical power. The test device 10 monitors the response time and stores the results in its internal memory for several minutes. When the GFCI is reset, electrical power is restored, and test device 10 displays the test results.

Test device 10 comprises two main stages, a fault current test stage 12, and a logic stage 14 for time measurements, memory and display. Test stage 12 comprises line and neutral terminals L and N for input power, a double pole test button 16a-b, and a full wave bridge rectifier 18, in series with two pairs of back-to-back Zener diodes 20 and 22. Rectifier 18 feeds fault current to a controller 24, comprising transistor switch pairs Q1-Q2 and Q3-Q4, and associated biasing resistors R26-R29.

A selector switch 30 and associated resistors R31-R34 control the level of fault current. A set of steering diodes D1, D2, D3 and D4 is provided to determine a current path in accordance with the quality of the ground connection established at the electrical socket being tested, as described further herein. An LED opto-coupler 35 and its associated transistor Q5 also operate via a rectifier bridge network 36 in relation to the quality of the ground connection.

Logic stage 14 comprises a display network between points X and Y which provides a visual indication of the test results via LEDs 50 (BAD GROUND), 52 (BAD GFCI), and 54 (OK). A set of FETs Q6, Q7 and Q8 control the operation of this network. Logic states corresponding to the appropriate visual indication are stored in timing capacitor 39 and memory capacitors 43, 44 and 45. Then reset button 46 is depressed, diodes D5, D6, D7 and D8 discharge, respectively, timing capacitor 39 and memory capacitors 43-45, zeroing the voltage and logic states.

As described further herein, logic stage 14 operates to measure the GFCI response time based on the operation of the RC charging network provided by resistor R48, capacitor 39, the logic trigger voltage provided by tank capacitor 41, and transistor-diode network 42. Tank capacitor 41 is charged by voltage Vcc (via resistor R25) to the breakdown voltage of Zener diode D18.

The purpose of test stage 12 is to allow a fault current to be generated as part of a GFCI response time test. This stage has three functions: 1) it creates the test fault current; 2) it couples a voltage signal 53 with information about the quality of the ground connection to logic stage 14; and 3) it assures that under a test condition in which a poor ground or no ground exists, the ground potential in the electrical socket being tested will not rise above a safe, low voltage value.

A clamping diode D19 is provided to ensure that voltage signal 53, which is an AC signal, does not rise above the DC voltage level of Vcc and damage the circuit. A set of filters are provided by resistors R59, R60 and the capacitors connected in parallel with them, to suppress spurious noise from charging the timing capacitor 39 and memory capacitors 43-45.

When test button 16a-b is open, rectifier 18 is disconnected from the system voltage, and no current flows to ground, or from the line terminal (L) to the neutral terminal (N). When test button 16a-b is depressed, rectifier 18 provides the system voltage less the voltage drop of the back-to-back Zener diode pair 20 and 22, so that a high voltage DC source is present at the output of rectifier 18, and point 18a is always positive with respect to point 18b.

Test button 16a-b is designed as a two-pole switch. Since it cannot be assumed that both poles will make contact at precisely the same moment, and since it is critical to avoid a transient hazard at the ground terminal, test device 10 is designed to assure that both poles are closed prior to applying the ground fault current. It should be noted that without this feature, if a bad ground connection exists, then when one pole of test button 16a-b connects to the line potential before the other, the ground wire will have the line potential applied to it (this is the hazard mentioned). As described further herein, two currents are involved in the test, one is the fault current and the other is a current to provide a voltage gap across either of Zener diode pairs 20 and 22, and these must both flow simultaneously.

Accordingly, transistors Q1-Q2 and biasing resistors R26-R27 act as an AND gate, so that when test button pole 16a makes contact and supplies high voltage with respect to ground, no current will flow until test button pole 16b makes contact. At that point, biasing resistors 26 and 27 switch on transistors Q1-Q2. The same arrangement is provided by transistors Q3-Q4 and biasing resistors R28, R29, to insure that should test button pole 16b make contact first, no current flows until test button pole 16a makes contact.

The output voltage of rectifier 18 is the source for the test fault current. Examining the voltage at point 18a with respect to the ground terminal and at point 18b with respect thereto, the following table is obtained, depending on four test cases defined in the table and discussed further herein. Table 1 assumes a system voltage of 220 volts and a voltage drop of 30 volts on each of the pair of Zener diodes 20 and 22.

## TABLE 1

| Case | Connection | Half Cycle | Point 18a | Point 18b | Va-Vb |
|------|------------|------------|-----------|-----------|-------|
| A | Line to Neutral per Fig. 1 | Positive | 190v | 30v | 160 |
| B | "       " | Negative | -30v | -190v | 160 |
| C | Line to Neutral opposite of Fig. 1 | Positive | 190v | 30v | 160 |
| D | "       " | Negative | -30v | -190v | 160 |

If the ground terminal of a particular electrical socket being tested has a proper ground connection, its potential with respect to the neutral terminal is ideally zero volts, and practically just a few volts. Each of the four test cases outlined in Table 1 is now examined.

### Case A:

When test button 16 is depressed, current flows from L to GND, through test button 16a, Zener diode pair 20, rectifier 18, transistors Q1-Q2, and resistor R31, to the junction formed by diodes D3-D4. Assuming a good ground connection exists, diode D4 is back-biased since the Zener diode pair 22 adds a voltage drop of 30 volts at the cathode of D4. This can be seen from the current flow delivered through D1, Q3, Q4, Zener diode pair 22, test button 16b and the neutral terminal. This current is not a fault current since it flows from line (L) to neutral (N), and its duty is to provide the voltage gap to Zener diode pair 22. The desired ground fault current that will actually flow to the ground terminal flows via diode D3, bridge 36 and opto-coupler 35 into ground (GND).

If the electrical socket at which the test device is connected does not have a good ground connection, the ground terminal potential will rise when fault current flows. If it rises above 30 volts with respect to the neutral terminal, steering diode D4 will divert the fault current toward neutral instead of through diode D3, which will be back-biased. Thus, the ground terminal is clamped to 30 volts, and opto-coupler 35 does not conduct. In this case there is no fault current, but voltage signal 53 indicates that a test has been initiated. In the absence of fault current, logic stage 14 will detect this and provide a "BAD GROUND" display via LED 50, such that the GFCI under test does not experience fault current and does not respond.

Even in the absence of fault current, there is a current path established from line to neutral through test button 16a, Zener diode pair 20, rectifier 18, diode D1, resistor R34, transistors Q3-Q4, again through rectifier 18, Zener diode pair 22 and test button pole 16b to neutral. This current has no effect on the visual display. As previously explained, its duty is to provide a voltage gap on Zener diode pair 22 above which the ground potential will never rise, and this gap is typically set to 30 volts.

### Case B:

In the negative half-cycle, fault current flows from the ground terminal to the line terminal. The current path is from ground (GND), through bridge 36, opto-coupler 35, diode D2, resistor R34, transistors Q3-Q4, rectifier 18, Zener diode pair 20, and test button pole 16a to the line terminal (L). Similar to the previous case, diode D1 is back-biased by negative 30 volts (see Table 1). If the ground potential becomes more negative than negative 30 volts, the current is diverted by steering diode D1, and D2 is back-biased. Conduction through diode D1 is completed via rectifier 18, Zener diode pair 22, push button pole 16b and the line terminal. This achieves the objective of clamping the ground terminal to negative 30 volts.

As before, the other current which provides the voltage gap is established via the neutral terminal, test button pole 16b, Zener diode pair 22, rectifier 18, transistors Q1-Q2, resistor R31, diode D4, rectifier 18 again, Zener diode pair 20, test button pole 16a and the line terminal.

Cases <u>C</u> and <u>D</u>:

In these cases, the order of line and neutral connections is interchanged, but due to rectifier 18, the output voltage between points 18a and 18b is the same as in cases A and B (as is shown in Table 1). Therefore, the operation is the same as that described in cases A and B.

The determination of whether the GFCI response time is within an acceptable standard is based on a time threshold set by logic stage 14, and is typically 70 milliseconds. Beyond this, the GFCI response time is considered unacceptable.

In the preferred embodiment, back-to-back Zener diode pairs 20 and 22 provide a voltage clamp of 30 volts in the case of a "bad" ground connection. The voltage clamp could also be achieved by a DIAC (also called SIDAC), which is a bilateral device capable of switching from a blocking state to a conducting state when the applied voltage of either polarity exceeds the breakover voltage. Since in the "on" state, the current through this device is limited by resistors R31-R34, the current never enters the negative resistance region of the device operation, and its behavior thereby simulates the characteristic of a pair of back-to-back Zener diodes.

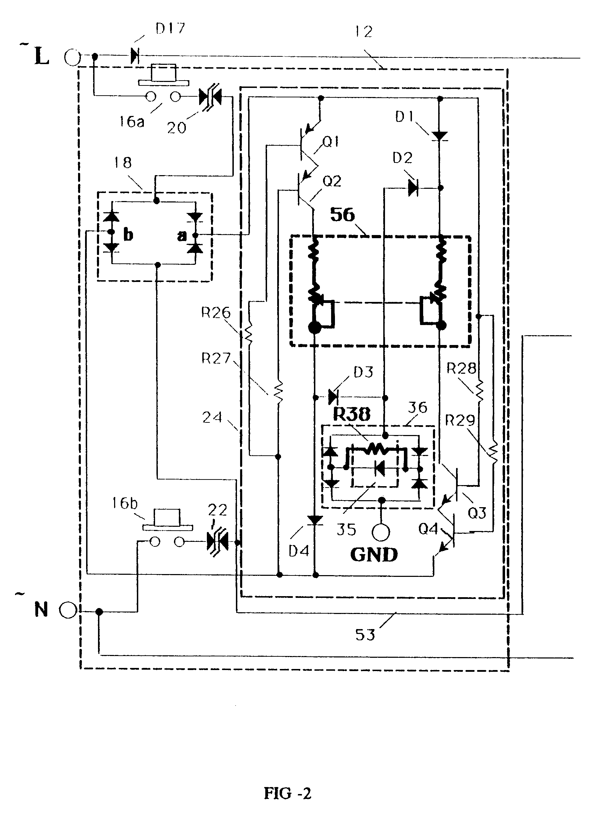

Selector switch 30 provides two values of fault current for use in the test, by allowing combination of resistors R31-R32, and R33-R34 to determine the fault current level. These determine a fault current level of 30 mA or 10 mA depending on the type of GFCI being tested. As shown in the alternative embodiment of Fig. 2, these resistors and selector switch 30 can be substituted by variable resistors R56 on the same shaft with a calibrated dial. By doing so, a plurality of fault current ranges can be used in the test, particularly the 300 mA range which is common in some countries and complies with the electric company requirement to protect the power generation equipment.

Also shown in Fig. 2 is a possible modification of opto-coupler 35 using a resistor R38 in parallel therewith. By selecting a proper value, the response of opto-coupler 35 is altered, and this provides a means to select a point at which the ground connection under test is determined to be a "bad" ground connection. For example, use of a 100 Ohm resistor across opto-coupler 35 will set a "bad" ground impedance threshhold of 750 Ohms, such that a ground impedance above this value is considered a "bad" ground connection,

The operation of logic stage 14 is now examined, assuming reset button 46 has been depressed, and diodes D5-D8 have discharged timing capacitor 39 and memory capacitors 43-45. When capacitor 45 is at a voltage lower than the gate voltage of FET Q8, the common line 47 is disconnected from line Y. Thus, the display network between X and Y cannot conduct and LEDs 50, 52 and 54 are off. Zener diode D9 conducts through "READY" LED 57 which is on.

When a test is initiated, voltage signal 53 causes current to flow through resistor R37 and diode D10, and quickly charges capacitor 45, such that FET Q8 conducts, connecting the common line 47 to Y, and enabling the display network between X and Y. Blocking diode D11 then maintains a 0.6 voltage drop, which turns off the "READY" LED 57.

The voltage signal 53 is also coupled through diode D12 and the RC timing network formed by timing capacitor 39 and resistor R48. This RC network is designed to reach the level of the Zener diode D13 breakdown voltage in network 42 in 2-3 times the nominal response time of a properly operating GFCI device. If the GFCI responds within this period and power is cut off, the timing capacitor 39 has not reached the breakdown voltage level of Zener diode D13 in network 42.

If, however, the GFCI response time is larger than the charging time determined by the RC network of timing capacitor 39 and resistor R48, then once capacitor 39 has charged to the breakdown voltage level of Zener diode D13, the transistor Q9 is turned on and capacitor 43 is charged sharply via diode D14 to the voltage permanently available at the power supply tank capacitor 41. The voltage of capacitor 43 appears as a logic "1" at the gate of FET Q6, signalling a "BAD GFCI". This signal is labelled "BG" for purposes of discussion.

If ground fault current flows through opto-coupler 35, its output transistor Q5 conducts and current flows via resistor R58 and diode D15 to charge capacitor 44, and this represents a logic signal present at the gate of FET Q7, which is denoted as a good ground "GG" when it is logic "1". If the socket under test has poor or no grounding at all, capacitor 44 is not charged and the gate of FET Q7 has logic "0". Table 2 presents a truth table of the display requirements to be provided by the display network between lines X and Y.

## TABLE 2

| Meaning | Signal "BG" | Signal "GG" | GND LED | GFI LED | OK LED |
|---|---|---|---|---|---|
| Bad GND | 0 | 0 | ON | OFF | OFF |
| Good GFI & GND | 0 | 1 | OFF | OFF | ON |
| Impossible | 1 | 0 | OFF | OFF | OFF |
| Bad GFI | 1 | 1 | OFF | ON | OFF |

There are several ways to perform this logic, with the preferred embodiment being shown in Fig. 1. The logic states are stored for several minutes due to the use of isolation diodes D14, D15, and D10, for memory capacitors 43-45 respectively, allowing them to charge but not to discharge via the diodes, and using FET transistors with a very large gate-to-source resistance. Thus, capacitors 43-45 can be charged, respectively, via diodes D14, D15 and D10, while they are discharged through respective FETs Q6, Q7 and Q8.

Once the user ascertains the test results through the visual display of LEDs 50, 52 and 54, test device 10 may be quickly returned to the ready state by use of reset button 46, providing a very low resistance path through each of diodes D6, D7, and D8 for respective memory capacitors 43-45. In addition, the timing capacitor 39 is also discharged via diode D5.

Examining the LED display network between lines X and Y, it can be seen that when LEDs 50 and 52 are lit because their corresponding transistors (Q10 and Q11) are turned on, the "OK" LED 54 is turned off. This is because the voltage drop on LED 54 is in series with the required breakdown voltage drop across Zener diode D16, so that only if both transistors are off (no "BAD GFCI" and no "BAD GND"), then LED 54 is turned on.

There is also provided an interlock so that when FET Q7 is on (GG=1, "GOOD GND"), it is saturated, thereby shorting the base to emitter of the transistor Q10 and forcing its operation at cutoff, which leaves LED 50 off. The power supply for logic stage 14 is provided by diode D17, dropping resistor R25, tank capacitor 41 and stabilizing Zener diode D18, while the display network is supplied by resistor R61.

The power required to maintain the display results in logic stage 14 can be supplied by a rechargeable battery. In this case, the LED display continues to be lit even though the power has been cutoff during the test by a GFCI device response. Furthermore, if capacitor 41 is increased it will supply the required energy for several seconds. In the latter case, Vcc line is to be connected to the line marked X and R61 eliminated.

In a variation of the logic stage 14, the RC timing network formed by timing capacitor 39 and resistor R48 can be adjusted by using a screw-driven variable resistance allowing different time thresholds to be obtained according to different specifications and various GFCI devices. A jumper-selected resistor achieves the same result.

A numerical time display readout could be added to display the response time of the GFCI under test. Using well-known techniques, a display counter is clocked by an oscillator of 1 KHz to display the results in milliseconds. The clock would be gated by signal 53 to start and stop, and would be reset by reset button 46. Capacitor 45 is employed to supply the power to the counter and retain the time result readout until power is resumed.

An alpha-numeric display can also be utilized to indicate the time result and also display the fixed data states BAD GFCI, BAD GND, and READY or a similar legend. In such an embodiment LEDs 50, 52, 54 and 57 would be eliminated. The "on" and "off" signals for these fixed data readouts are taken from transistors Q8, Q10 and Q11.

After a test, the results are retained for a period of approximately 5 minutes if the reset button 46 is not immediately depressed. After this period, the energy stored in memory capacitors 43-45 is dissipated and the circuit enters the ready state. During the last 5 seconds of capacitor discharge, the transient from one display result to the ready LED occurs gradually so there could be a situation where more than one LED is lit simultaneously.

Another transistor may be provided in parallel to reset button 46 so as to short circuit it momentarily before the retention time is over, enabling a sharp transition to the ready state. This could be accomplished by taking the gate signal of transistor Q8, inverting it and using it to drive the transistor connected across reset button 46.

In summary, the innovative design of test device 10 provides an additional level of information in verifying the proper operation of the GFCI and the grounding connection of the electrical socket, assuring additional safety.

Having described the invention with regard to certain specific embodiments thereof, it is to be understood that the description is not meant as a limitation, since further modifications may now suggest themselves to those skilled in the art and it is intended to cover such modifications as fall within the scope of the appended claims.

## Claims

1. In an electrical system having line, neutral and ground connections and being protected by a ground fault circuit interrupter (GFCI) device, a test device for measuring an operational response time of the GFCI device in a test procedure, said test device comprising:

   means for applying a ground fault current to initiate the test procedure, said ground fault current developing a voltage at the ground connection with respect to neutral if the ground connection has non-zero impedance;

   means for limiting said voltage to a low value, if said voltage is developed at the ground connection;

   means for detecting said applied ground fault current and measuring a time period elapsed between said detection and an occurrence of the GFCI device operation;

   means for comparing said elapsed time period with a predetermined response time period; and

   means responsive to said comparing means for indicating a performance result of the GFCI device determined by the greater of said elapsed time period and said predetermined response time period.

2. The device of claim 1 wherein if said ground impedance is above a predetermined threshold value, said GFCI device is inoperative, providing an LED indication on said indicating means.

3. The device of claim 1 provided as a portable plug-in unit which can be plugged into a household electrical socket for testing purposes, wherein said ground fault current applying means comprises a test button connecting the line and ground terminals of said electrical socket.

4. The device of claim 3 wherein said test button is provided with a cover to prevent inadvertent depression.

5. The device of claim 3 wherein if said electrical socket is properly grounded, said ground fault current operates the GFCI device protecting the system, thereby cutting off power to said electrical socket.

6. The device of any of claims 1-5 wherein said means for measuring said elapsed time period comprises a charging voltage provided during said period between the test procedure initiation and the GFCI device operation, said charging voltage being fed to a capacitor wherein it develops a voltage level which is compared with a predetermined voltage level representing said predetermined response time period associated with a proper response time of the GFCI device.

7. The device of claim 6 wherein said indicating means comprises a memory capacitor for storing, and an LED for indicating, a logic state corresponding to an unsatisfactory GFCI performance result, when said voltage level exceeds said predetermined voltage level.

8. The device of claim 7 wherein said logic state corresponding to said unsatisfactory GFCI performance result is stored prior to interruption of electrical power by the GFCI device operation and is displayed after electrical power is restored following the GFCI device operation.

9. The device of claim 7 further comprising internal power storage means, and wherein said logic state corresponding to said unsatisfactory GFCI performance result is stored prior to interruption of electrical power by the GFCI device operation and is displayed by said LED via said internal power storage means before electrical power restoration after the GFCI device operation.

10. The device of any of claims 7-9 further comprising a reset button for erasing said stored logic states, enabling re-performance of the test procedure.

11. The device of claim 6 wherein said voltage level does not exceed said predetermined voltage level, and wherein said indicating means comprises an LED for indicating a satisfactory GFCI performance result.

12. The device of any of claims 1-11 wherein said indicating means stores information relating to said performance result for a minimum period of approximately 5 minutes after the GFCI device operation.

13. The device of any of claims 1-12 further comprising a selector for selecting a sensitivity level of the GFCI device operation during performance of the test.

14. The device of any of claims 1-13 wherein said indicating means comprises an alphanumeric display.

15. The device of any of claims 1-14 wherein said predetermined response time period is easily adjustable.

16. In an electrical system having line, neutral and ground connections and being protected by a ground fault circuit interrupter (GFCI) device, a method for measuring an operational response time of the GFCI device in a test procedure, said method comprising the steps of:
    applying a ground fault current to initiate the test procedure, said ground fault current developing a voltage at the ground connection with respect to neutral if the ground connection has non-zero impedance;
    limiting said voltage to a low value, if said voltage is developed at the ground connection;
    detecting said applied ground fault current and measuring a time period elapsed between said detection and an occurrence of the GFCI device operation;
    comparing said elapsed time period with a predetermined response time period; and
    indicating, in response to said comparing step, a performance result of the GFCI device determined by the greater of said elapsed time period and said predetermined response time period.

17. The method of claim 16 wherein said GFCI performance result is stored prior to interruption of electrical power by the GFCI device operation and is displayed after electrical power is restored following the GFCI device operation.

18. The method of claim 16 wherein said GFCI performance result is stored prior to interruption of electrical power by the GFCI device operation and is displayed before electrical power is restored following the GFCI device operation.

19. In an electrical system protected by a ground fault circuit interrupter (GFCI) device, a test device for measuring an operational response time of the GFCI device operation in a test procedure, substantially as described herein by way of example and with reference to the drawings.

20. In an electrical system protected by a ground fault circuit interrupter (GFCI) device, a method of measuring an operational response time of the GFCI device operation in a test procedure, substantially as described herein by way of example and with reference to the drawings.

FIG-1

FIG -2